Europäisches Patentamt

European Patent Office    (11) Publication number: **0 066 087**
**B1**

Office européen des brevets

(12) # EUROPEAN PATENT SPECIFICATION

(45) Date of publication of patent specification: **04.09.85**    (51) Int. Cl.⁴: **G 01 R 31/28,** G 01 R 1/073, H 01 B 1/24

(21) Application number: **82103554.0**

(22) Date of filing: **27.04.82**

(54) Inspection of unsintered single layer or multilayer ceramics using a broad area electrical contacting structure.

(30) Priority: **26.05.81 US 267321**

(43) Date of publication of application:
**08.12.82 Bulletin 82/49**

(45) Publication of the grant of the patent:
**04.09.85 Bulletin 85/36**

(84) Designated Contracting States:
**DE FR GB IT**

(56) References cited:
EP-A-0 066 070
EP-A-0 066 071
EP-A-0 066 086
FR-A-2 477 758
US-A-3 016 486
US-A-4 169 816

ELECTRONICS, Vol. 53, No. 22, October 1980
New York L. LOWE "Elastomers Cushion
Prototype Reworks" page 44

(73) Proprietor: **International Business Machines Corporation**
**Old Orchard Road**
**Armonk, N.Y. 10504 (US)**

(72) Inventor: **Chang, Tai-Hon Philip**
**36 Pond Hill Road**
**Cappaqua New York 10514 (US)**
Inventor: **Coane, Philip James**
**14 Carmine Drive**
**Mahopac New York 10541 (US)**
Inventor: **Hohn, Fritz-Jurgen**
**47 Whippoorwill Road E.**
**Armonk New York 10504 (US)**
Inventor: **Molzen, Walter William, Jr.**
**35 Morningside Drive**
**Patterson New York 12563 (US)**
Inventor: **Zingher, Arthur Richard**
**40 Winthrop Avenue**
**Elmsford New York 10523 (US)**

(74) Representative: **Lancaster, James Donald**
**IBM United Kingdom Patent Operations Hursley Park**
**Winchester, Hants, SO21 2JN (GB)**

**0 066 087**

(56) References cited:

IBM TECHNICAL DISCLOSURE BULLETIN Vol.
22, No. 7, December 1979, New York L.A.
GLADSTEIN et al. "Low Force Microcircuit
Probe" pages 2824 to 2826

SCANNING ELECTRON MICROSCOPY 1971/1
H.P. FEUERBAUM "VLSI Testing using the
Electron Probe" pages 285 to 296

## Description

### Technical Field

This invention relates to multilayer ceramic (MLC) carriers for electronic circuit chips and more particularly to apparatus and methods for inspecting MLC laminates, sublaminates, and greensheet material prior to sintering. It is a particularisation of the broad concept of our European Application 0066086 (US Serial No. 267,272).

### Background Art

Multilayered ceramic circuit modules are employed by the electronic industry today for carrying and interconnecting large scale integrated circuit chips. One type of such modules, generally known as laminated MLC (or simply "MLC") modules or substrates, are formed as follows.

Sheets of flexible unfired (green) ceramic material are cast. The green ceramic sheet is punched with holes (known as vias) in a desired pattern; the punched sheet is then screened with a metallic paste through a mask to form a desired pattern which fills the vias with paste, forms paths of paste on the surface (known as lines) and sometimes forms large areas of paste on the surface (known as pads); unfired screened sheets (known as greensheets) may then be optically inspected; a number of greensheets having generally different screening patterns are then stacked and pressed together, forming what is known as a laminate; the laminate is then fired (also known as sintered) in a furnace to obtain a desired configuration of conducting lines, insulation layers, layer to layer connections, and reference and power planes; the sintered laminate is next plated with metal and electrically tested; pins and chips are attached at this point and chip-in-place testing is done; module wiring may be altered at this point or after the earlier electrical test by laser deletion of surface lines or by adding discrete wires attached by ultrasonic bonding. This process is described in much more complete detail, for example, in B. Clark et al., "IBM Multichip Multilayer Ceramic Modules for LSI Chips — Design for Performance and Density", IEEE Transactions on Components, Hybrids, and Manufacturing Technology, Vol. CHMT-3, No. 1, pages 89—93 (March 1980) and in A. Blodgett, Jr., "A Multilayer Ceramic, Multi-Chip Module", IEEE Transactions on Components, Hybrids, and Manufacturing Technology, Vol. CHMT-3, No. 4, pages 283—285 (Dec. 1980), both of which are hereby incorporated by reference.

Two examples of pastes are given in IBM TDB January 1979 p. 3091 and October 1978 p. 1864. Typically they include an insulating organic binder and a solvent, as well as metal particles.

Given these processing steps, the first electrical test has occurred after sintering and plating, at a point where significant manufacturing costs have already occurred. Electrical testing after sintering and prior to plating, while preferred from a cost basis, is not known in the art presumably because of the nature of the surface which results from firing metallic paste and certain deficiencies in existing testing technology. Optical inspection of greensheets can identify some defects in greensheets but internal voids in the paste, for example, cannot be detected. Obviously, optical testing of laminates could not detect internal defects. Electrical testing before sintering is not known in the art, heretofore, because it was assumed that metallic paste is an insulator in the unfired state.

We have discovered surprisingly that unfired metallic paste of the type used to form MCL modules has electrical properties such that it can be electrically tested within a matrix of unfired ceramic material of the type used to form MLC modules. Heretofore, it was assumed that electrical properties of these materials were not suitable for a practical electrical test until after sintering e.g. the resistance between two access points may be at least $10^5$ ohms. The ability to electrically inspect green MLC ceramic material has made the electrical testing of sublaminates during MLC module manufacture feasible and desirable. These discoveries are described and claimed in detail in our European Application 0066086 (US Serial No. 267,272).

A problem encountered in electrically testing unsintered MLC laminates, sublaminates and greensheets is that the unfired materials are very soft and easily damaged. Conventional methods for electrically contacting electronic circuits or modules resulted too often in physical damage to the soft unfired specimen, so that as a result of the electrical test, many specimens became worthless for further use in the manufacturing process. Accordingly, non-contacting methods were explored, see our European Applications 0066071 and 0066070 (US Serial Nos. 267,118 and 267,119).

### Disclosure of Invention

Method and apparatus are disclosed for electrically inspecting unsintered single or multiple layer ceramic specimens containing or carrying metal paste patterns of the type commonly used to ultimately form laminated multilayer ceramic (MLC) carriers for large scale integrated (LSI) chips. A relatively large surface area of an unsintered ceramic specimen (large in comparison with the minimum feature size of the paste patterns) is temporarily electrically contacted with a conforming electrode. The conforming electrode makes non-damaging electrical contact to any metallic paste exposed at the contacted area. Electric charge is either collected or delivered by this electrode, depending upon the mode of operation. The electrical continuity of metallic paste paths which contact the electrode and extend through the unfired ceramic specimen to surface positions not contacted by the electrode are tested either by delivering electric charge to the other surface locations and correlating therewith the collection of charge by the electrode, or by delivering charge by the electrode to all paste paths in contact therewith and detecting the presence of charge at the other surface locations. A preferred method either for delivering charge to such other surface locations or for detecting charge at such other surface locations is by using an electron probe beam. Various embodiments for the conforming electrode are described.

Brief Description of the Drawings

FIG. 1 schematically shows a system for electrically testing unsintered ceramic samples containing paths of metallic paste using one kind of conformable electrode and illustrates one mode of operation.

FIGS. 2.1 and 2.2 schematically show another system for electrically testing unsintered ceramic samples containing paths of metallic paste using another kind of conformable electrode and illustrates another mode of operation.

FIG. 3 shows still another kind of conformable electrode and illustrates in phantom an electrical testing variation.

FIG. 4 shows yet another kind of conformable electrode.

Description of the Preferred Embodiments

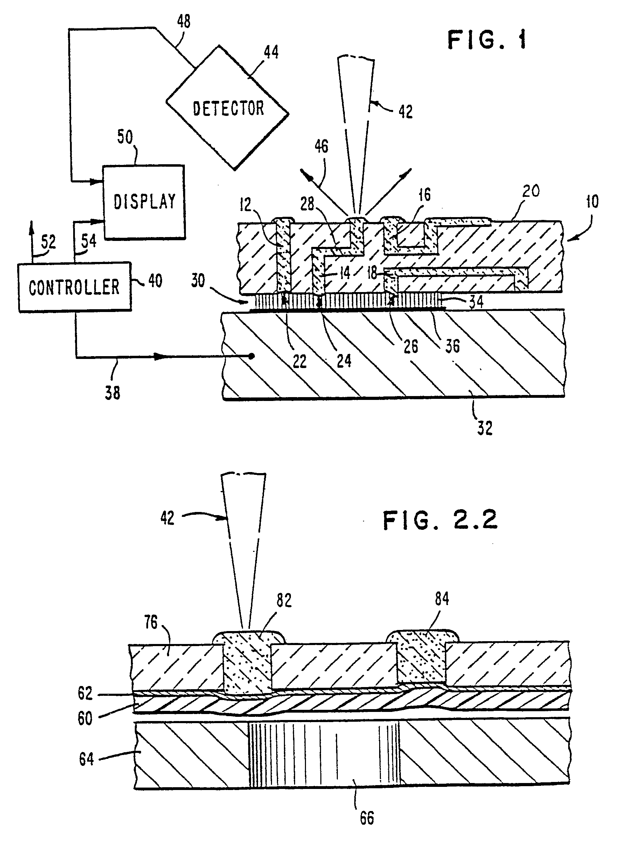

Referring now to FIG. 1, the typical structure of an unsintered multilayer ceramic laminate or sub-laminate specimen is illustrated, along with apparatus for electrically testing the specimen. The multilayer ceramic specimen 10 typically has pathways 12, 14, 16, 18 within a laminated green (unfired) ceramic body 20. Vertical paths or portions of paths through the body 20 have been formed when vias in individual greensheets align with each other while horizontal paths or portions of paths are formed from lines in greensheets. The pathways 12, 14, 16, 18 have ideally been filled completely with a metallic paste material during fabrication which upon sintering will form electrically conducting paths. The metallic paste typically does not form a perfectly flush surface with the surface of the ceramic body 20. Thus, some paste is typically lower than the ceramic body surface as illustrated at 22, while some other paste is higher, than the ceramic body surface as illustrated at 24. Sometimes paste is partly below and partly above the ceramic body surface as shown at 26. Due to the screening process for applying metallic paste to greensheets, the paste is typically higher than the ceramic surface on one side (shown here as the top side) and level with the ceramic surface on the other side (shown here as the bottom side). Pathways typically lead from one major surface to the other (pathways 12, 14) and from one major surface into the ceramic body and back to the same major surface (pathways 16, 18).

A typical internal defect which occurs in a multilayer ceramic specimen is a void such as shown at 28 in path 14. A void which is sufficiently large results after firing in an electrical path which is broken. Another internal typical defect is when a path becomes inadvertently connected to another path. This results in a short between two electrical paths after firing. In addition to internal defects, a surface defect may exist in a single or multilayer ceramic specimen which will become an internal defect as soon as the specimen is laminated with other specimens to form a specimen having a larger number of layers. An example of such a surface defect is a via which has been so incompletely filled that the unfilled space will become an internal void upon lamination with other specimens. A via may also become so overfilled that the excess paste may connect two paths not intended to become connected when the specimen is laminated with other specimens. An inadvertent break in a surface line of paste is another example of a possible surface defect. It is desirable to be able to detect these defects and in accordance with this invention such defects may be detected, at least in part, by electrically testing the conductivity of paste paths through use of at least one conformable broad area electrical contact which does not damage unfired single or multilayer ceramic specimens.

The conformable electrode 30 illustrated in FIG. 1 comprises a rigid, preferably electrically conductive plate 32 supporting an array of conductive fibers 34 oriented substantially parallel to each other and in side-to-side contact with each other. The conductive fibers 34 are held in this orientation by glue or paste 36, which preferably also is conductive. The glue 36 may or may not also bond the fiber array to plate 32. Electrical connection is made to the conductive fibers 34 of electrode 30 via lead 38, preferably by electrical contact to plate 32. Direct electrical contact by lead 38 with the fiber array is a possible alternative as well as direct electrical contact with the glue 36, assuming the glue is electrically conductive. Obviously, an indirect electrical connection to the fiber array via the plate 32 requires that plate 32 be conductive and preferably also glue 36. Electrically conductive glues are readily available commercially.

Fibers 34 are sufficiently flexible that they bend individually to conform the top surface of the array to an irregular contacting surface such as is typical of an unfired single or multilayer ceramic specimen. Depending upon the weight of the specimen in relation to the resiliency of the fiber array, conforming contact may be caused automatically by virtue of gravitational force acting upon the specimen. Additional force may also be applied in any convenient manner, if necessary, to make conforming contact.

An experimental electrode structure 30 as illustrated in FIG. 1 was actually constructed as follows. Commercially available carbon fiber cloth was cut into about 500 virtually identical narrow strips (about 9 mm × 60 mm) oriented such that fibers lie transverse to each strip. The carbon cloth strips were then stacked in side-to-side relationship in a frame, squeezed together into close contact and glued together at one side of the array using silver paste. There were about 10 cloth strips per millimeter in the glued structure. Longitudinal carbon fibers in the cloth strips were then removed using tweezers and the unglued side was made more planar with an ordinary electric shaver. The resulting structure had a conforming surface which closely resembles velvet cloth. Other methods are obviously possible for forming a velvet-like surface out of carbon fibers or the like. While carbon fibers are preferred, any fine flexible electrically conductive fiber could be used instead.

The constructed velvet-like electrode was positioned on a rigid metallic plate and an unfired multilayer ceramic specimen placed on top. The weight of the specimen was sufficient to cause the electrode to make common electrical contact with all of the exposed vias in the contacted bottom surface area and no damage occurred to the unfired metallic paste or ceramic.

FIG. 1 illustrates one system for electrically testing unsintered ceramic specimens using a broad area conforming electrical contact. Controller 40 applies an electrical signal to electrode 30 via lead 38. Either the voltage level of lead 38 may be controlled, or the current flowing to or from electrode 30 may be controlled, or the charge delivered or taken from electrode 30 may be controlled. In any event, electrical charge will flow through the paste filled pathways in the ceramic body 20 and tend to change the voltage level of the paste at the other end of the connected pathways. In the illustration, the ends of pathways 12 and 18 remote from electrode 30 would tend to experience a change in voltage level. The remote end of pathway 14 would not tend to experience the same change because charge flow through the pathway is interrupted (or at least impeded) by the void 28. The voltage level at the remote ends of pathways 12, 14, and 16 are then detected using a scanning electron probe beam 42.

Probe beam 42 is a conventional SEM type probe beam which may be scanned about in raster scan mode or vector scan mode as is well understood in the art. Details of the construction of an SEM type electron probe beam are well known and form no part of this invention.

The voltage level of a surface subjected to an electron beam affects the energy of secondary electrons emitted from the surface. This phenomenon is described in great detail, for example, in the cited copending European Application 82103178.8 (U.S. Serial No. 267,118). A suitable detector 44 descriminates between secondary electrons which have energy corresponding to the changed voltage state such as can be expected at the remote end of pathway 12 and secondary electrons 46 which have energy corresponding to the unchanged voltage expected at the remote end of pathway 14 to produce a signal 48. Secondary electron detectors of this kind are readily available and understood by those of ordinary skill in SEM art. Details of this sensing system do not form part of this invention.

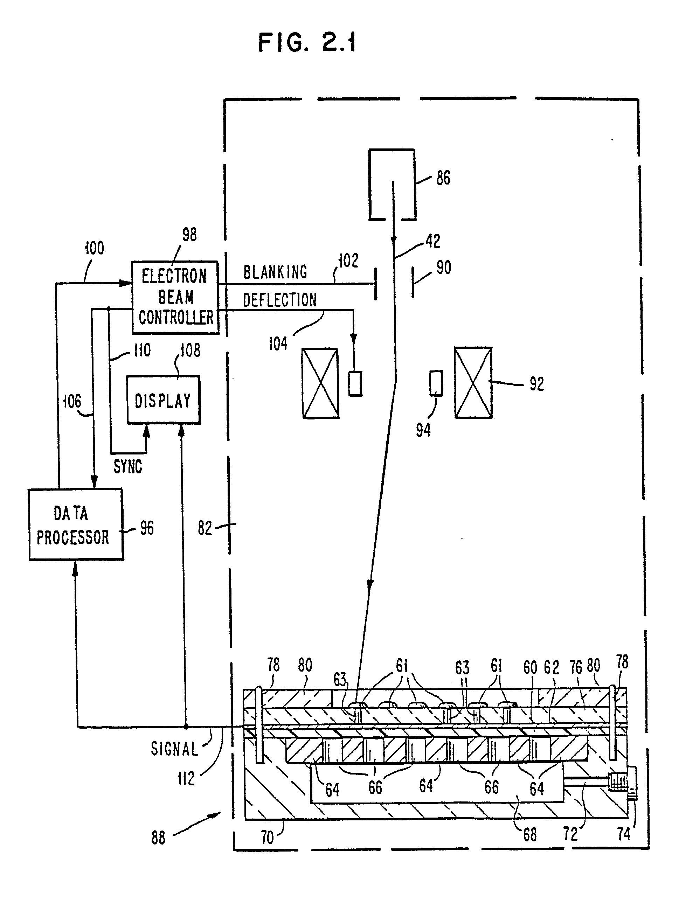

Signal 48 is displayed on device 50. Controller 40 controls the position of the electron probe beam via line 52 and synchronizes the display therewith via line 54. Display 50 preferably is a two dimensional pictorial display device such as a CRT. However, other displays could be used instead. Signal 48 also could be sent to a data processor as illustrated in FIG. 2.1 in addition to or in place of the display.

FIG. 2.1 illustrates a different testing system using a different conformable electrode. A thin flexible sheet 60 of mylar or other similar plastic carries a deposited conductive film 62 on the top side thereof and rests, in turn, on top of a flat plate 64 having perforations 66. The plate is positioned above a fixed volume enclosed cavity 68 defined by a fixture body 70. The plate 64 and body 70 completely enclose cavity 68 except for perforations 66. The mylar material 60 completely covers all perforations 66 and is sealed to the top periphery of the fixture body 70 to provide a vacuum tight seal. The cavity 68 is evacuated to a predetermined partial atmospheric pressure via port 72 and sealed off by seal 74.

A greensheet 76 is placed over the mylar film 60 in contact with the conductive film 62 and accurately positioned by alignment pins 78 which extend from the fixture body 70 through punched holes in the greensheet. A frame 80 acts as a weight to hold the periphery of the greensheet against the flexible film.

When the assembly is placed in an electron beam system vacuum chamber 82 and the chamber is evacuated, the partial atmospheric pressure in the cavity 68 causes the flexible sheet 60 to uniformly press against the underside of greensheet 76 and conform to the irregularities of the greensheet surface. The flexible sheet is held in conforming contact with the greensheet by a higher gas pressure inside cavity 68 than the gas pressure in the vacuum chamber surrounding the greensheet during electrical test. The conductive film 62 on the flexible sheet 60 thus electrically contacts any metallic paste exposed at the underside of the greensheet in a non-damaging manner.

FIG. 2.2 is an enlarged view of a greensheet 76 and the flexible film 60 and plate 64 illustrated in FIG. 2.1. The greensheet 76 has a via 82 where the paste was pushed too far through the via and protrudes from the bottom surface of the greensheet and another via 84 where the paste was not pushed far enough into the via and fails to fully fill the via. These are not actually defective vias because during lamination greensheets are pressed together. Furthermore the vias and lines of a greensheet under this greensheet in a stack probably will have protruding paste on the top side, as is typical, and as is shown on the top side of these vias. As illustrated, the flexible sheet 60 conforms to small irregularities such as this so that the conductive film 62 contacts both of these vias.

Returning now to FIG. 2.1, an electron beam source 86 generates electron beam 42 which may be blanked or turned off by blanking means 90. Electron beam 42 is focussed by one or more focussing coils 92 and may be deflected in two dimensions by coils 94. Data processor 96 may contain, for example, a representation of a correct electrical test pattern for greensheet 76. Signals from processor 96 to electron beam controller 98 via line 100 direct the controller to scan the greensheet in a desired pattern, which is done by controller 98 via blanking signals and deflection signals on lines 102 and 104 respectively. The processor 96 may be generating synchronization signals for controller 98, but in the illustrated system, controller 98 generates the synchronization signals and supplies them to the processor 96 via line 106. Synchronization signals (or x-y position signals where vector scan mode is used) are also supplied to a display 108 via line 110. Line 112 is electrically in contact with the conductive film 62 and supplies a signal from the conformable electrode 88 to display 108 and processor 96.

When an electron beam of suitable energy strikes a surface such as the top of a via, the surface becomes electrically charged. Vias which do not have substantial voids (and all conductive paste pathways in general) conduct some charge to the remote end of the via (or pathway). If the remote end is in electrical contact with a conformable electrode, the charge is collected by the conformable electrode as a signal. Obviously, a signal could be in the form of a charge signal, a current signal (actually a charge flow rate) or a voltage signal (actually a charge accumulation). Herein when it is said that charge is applied or detected it is understood that such can (and probably will) be done by applying or detecting voltage or current instead. The term charge also equally applies to positive as well as negative charge or charging. The charge signal or pattern collected by the conformable electrode may be displayed in synchronism with the electron beam scan and/or compared in processor 96 with a correct signal or pattern to automatically detect defects.

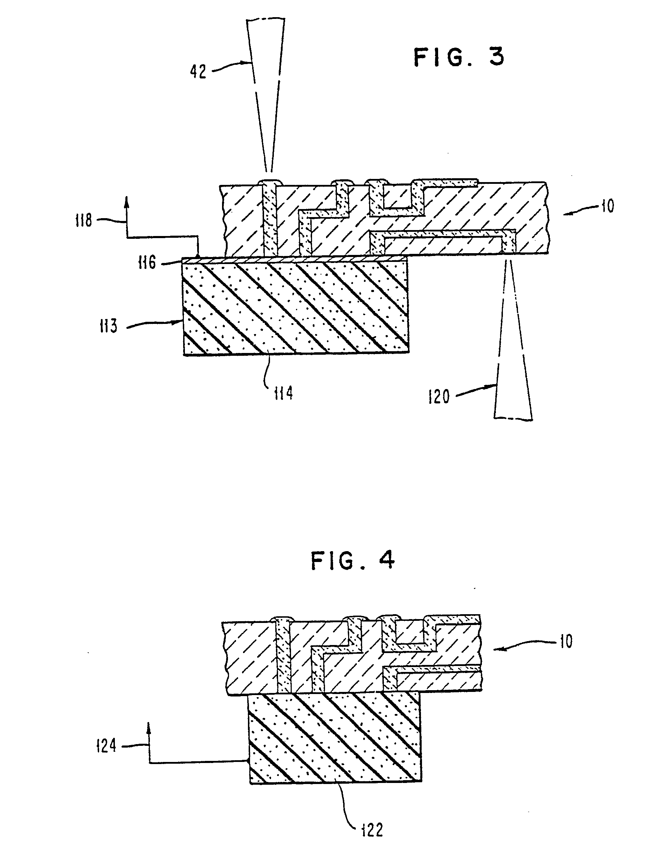

FIG. 3 illustrates still another conformable electrode 113. A soft spongy material 114 supports a conductive film 116 having an electrical connection to line 118, which may either apply or collect charge. Unfired ceramic specimen 10 rests on electrode 113. The spongy material 114 applies a uniformly distributed upward force on film 116 in opposition to the downward directed force upon specimen 10 (arising for example by virtue of the action of gravity), thereby conforming film 116 to the bottom surface of specimen 10 and in electrical contact therewith. FIG. 3 further illustrates in phantom an electron beam 120 either applying charge or sensing the charge state of paste filled pathways which have a remote end at another portion of the same surface to which conforming contact is being made with an electrode. It should be apparent that two electron beams could be used simultaneously as well as more than one discrete conformable electrode depending upon the type and nature and complexity of the electrical test desired. Particular details of the electrical test method or mode of operation which is used in connection with the conformable electrode do not form part of this invention. Detailed descriptions of such methods and modes of operation may be found in the cited co-pending European applications and in the prior art references identified therein.

FIG. 4 illustrates a further conformable electrode embodiment. In this embodiment, the conformable electrode comprises a block or plate electrically conducting elastomer 122 to which electrical contact via line 124 is made.

Many modifications and variations of our invention will be apparent to those of ordinary skill in this art and may be made without departing from the scope of our invention as defined by the following claims. For example, obviously any of the described conformable electrodes could be used either as a charge applying electrode or as a charge collecting electrode and any of the conformable electrodes could be used with either greensheets or laminated assemblies or subassemblies of greensheets.

## Claims

1. Method of electrically inspecting an unsintered single layer or multilayer ceramic containing lines and/or pathways of paste sinterable to metal characterized by the use of a broad area conforming electrode for temporarily electrically contacting a relatively large surface area of said unsintered ceramic, said electrode making uniform non-damaging common electrical contact to any paste exposed at the contacted surface area.

2. Method as defined in Claim 1 wherein said conforming electrode comprises an electrically conducting elastomer.

3. Method as defined in Claim 1 wherein said conforming electrode comprises a flexible sheet which is electrically conducting on at least one side thereof.

4. Method as defined in Claim 3 wherein said flexible sheet comprises a mylar sheet with a deposited layer of metal on one side thereof.

5. Method as defined in Claim 3 or 4 wherein said flexible sheet is uniformly pushed against said unsintered ceramic.

6. Method as defined in Claim 5 wherein said flexible sheet is uniformly pushed against said unsintered ceramic by a layer of spongy material.

7. Method as defined in Claim 5 wherein said flexible sheet is uniformly pushed against said unsintered ceramic by a difference in gas pressure on opposing sides of said flexible sheet.

8. Method defined in Claim 1 wherein said conforming electrode comprises a velvet-like electrically conducting material with projecting conductive fibers.

9. Method as defined in Claim 8 wherein said electrically conducting fibers comprise carbon fibers.

10. Method as defined in any preceding claim including scanning with an electron beam a different surface region of the ceramic from that contacted by the electrode, and measuring current, voltage or charge collected by the electrode.

11. Apparatus for carrying out the method of Claim 7 and comprising in addition to said electrode in the form of a flexible sheet, a substantially rigid fixture having an enclosed cavity except for perforations in a wall region thereof, said flexible sheet covering said perforations and being sealed to said fixture around the periphery of the perforated wall region, said sheet having an electrically conductive surface facing the specimen; and means for holding the periphery of unsintered ceramic single layer or multilayer ceramic to be inspected against said flexible sheet, the gas pressure within said enclosed cavity being such that during inspection of said ceramic said flexible sheet is held in conforming contact with said ceramic by a higher gas pressure inside said cavity than the gas pressure at said ceramic.

12. Apparatus as claimed in claim 11 including an E-beam chamber which contains the ceramic and said fixture, and which can be evacuated.

13. Apparatus for carrying out the method of claim 1 in which said conforming electrode comprises a velvet-like electrically conducting material with projecting conductive fibers.

14. Apparatus as claimed in claim 13 wherein said fibers comprise carbon fibers.

**Revendications**

1. Procédé d'inspection électrique d'une céramique non frittée à couche unique ou à couches multiples contenant des lignes ou/et des trajets d'une pâte métallique pouvant être frittée, caractérisé par l'utilisation d'une électrode de conformation de grande surface servant à établir un contact électrique temporaire avec une zone de surface relativement étendue de ladite céramique non frittée, ladite électrode établissant un contact électrique commun uniforme, ne créant aucun endommagement, avec toute pâte exposée, au niveau de la surface contactée.

2. Procédé selon la revendication 1, dans lequel ladite électrode de conformation comporte un élastomère électriquement conducteur.

3. Procédé selon la revendication 1, selon lequel ladite électrode de conformation comporte une feuille souple qui est électriquement conductrice sur au moins l'une de ses faces.

4. Procédé selon la revendication 3, selon lequel ladite feuille souple comporte une feuille de mylar munie d'une couche de métal déposée sur l'une de ses faces.

5. Procédé selon la revendication 3 ou 4, selon lequel ladite feuille souple est pressée uniformément contre ladite céramique non frittée.

6. Procédé selon la revendication 5, selon lequel ladite feuille souple est pressée uniformément contre ladite céramique non frittée au moyen d'une couche d'un matériau spongieux.

7. Procédé selon la revendication 5, selon lequel ladite feuille souple est pressée uniformément contre ladite céramique non frittée, par une différence de pression de gaz sur les faces opposées de ladite feuille souple.

8. Procédé selon la revendication 1, selon lequel ladite électrode de conformation comprend un matériau électriquement conducteur ressemblant à du velours et comportant des fibres conductrices en saillie.

9. Procédé selon la revendication 8, selon lequel lesdites fibres électriquement conductrices comportent des fibres de carbone.

10. Procédé selon l'une quelconque des revendications précédentes, incluant l'exploration, par un faisceau électronique, d'une zone de la céramique, qui diffère de celle contactée par l'électrode, et la mesure du courant, de la tension ou de la charge collectée par l'électrode.

11. Appareil pour la mise en oeuvre du procédé selon la revendication 7, et incluant, en plus de ladite électrode réalisée sou la forme d'une feuille souple, un support essentiellement rigide comportant une cavité fermée hormis au niveau de perforations situées dans une partie de la paroi de cette cavité, ladite feuille souple recouvrant lesdites perforations et étant scellée audit support sur la périphérie de la région de la paroi perforée, ladite feuille comportant une surface électriquement conductrice située en face de l'échantillon, et des moyens pour maintenir le pourtour de la céramique non frittée à une couche ou à plusieurs couches devant être inspectée, contre ladite feuille souple, la pression du gaz à l'intérieur de ladite cavité fermée étant telle que pendant l'inspection de ladite céramique, ladite feuille souple est maintenue en contact de conformation avec ladite céramique sous l'effet d'une pression du gaz à l'intérieur de ladite cavité, supérieure à la pression du gaz au niveau de ladite céramique.

12. Appareil selon la revendication 11, incluant une chambre à faisceau électronique qui contient la céramique et ledit support et dans lequel le vide peut être établi.

13. Appareil pour la mise en oeuvre du procédé selon la revendication 1, selon lequel ladite électrode de conformation comporte un matériau électriquement conducteur semblable à du velours et comportant des fibres conductrices en saillie.

14. Appareil selon la revendication 13, selon lequel lesdites fibres comportent des fibres de carbone.

**Patentansprüche**

1. Verfahren zur elektrischen Untersuchung einer ungesinterten Einschicht- oder Mehrschichtkeramik, welche Linien und/oder Durchgänge aus zu Metall sinterbarer Paste enthalten, gekennzeichnet durch die Verwendung einer sich einem breiten Bereich anpassenden Elektrode zur vorübergehenden elektrischen Kontaktierung eines verhältnismäßig großen Oberflächenbereichs der ungesinterten Keramik, wobei die Elektrode einen gleichförmigen beschädigungsfreien gemeinsamen elektrischen Kontakt mit am kontaktierten Oberflächenbereich freiliegender Paste macht.

2. Verfahren nach Anspruch 1, bei welchem die sich anpassende Elektrode ein elektrisch leitendes Elastomer umfaßt.

3. Verfahren nach Anspruch 1, bei welchem die sich anpassende Elektrode eine biegsame Folie umfaßt, welche an wenigstens einer ihrer Seiten elektrisch leitend ist.

4. Verfahren nach Anspruch 3, bei welchem die biegsame Folie eine Mylar-Folie mit einer auf einer Seite derselben abgeschiedenen Schicht aus Metall umfaßt.

5. Verfahren nach Anspruch 3 oder 4, bei welchem die biegsame Folie gleichförmig gegen die ungesinterte Keramik gedrückt wird.

6. Verfahren nach Anspruch 5, bei welchem die biegsame Folie durch eine Schicht aus schwammförmigem Material gleichförmig gegen die ungesinterte Keramik gedrückt wird.

7. Verfahren nach Anspruch 1, bei welchem die biegsame Folie durch eine Differenz des Gasdrukkes an gegenüberliegenden Seiten der biegsamen Folie gleichförmig gegen die ungesinterte Keramik gedrückt wird.

8. Verfahren nach Anspruch 1, bei welchen die sich anpassende Elektrode ein samtartiges elektrisch leitendes Material mit abragenden leitenden Fasern umfaßt.

9. Verfahren nach Anspruch 8, bei welchen die elektrisch leitenden Fasern Kohlenstoffasern umfassen.

10. Verfahren nach irgendeinem vorstehenden Anspruch, welches das Abtasten eines von dem mit der Elektrode kontaktierten Oberflächenbereich verschiedenen Oberflächenbereichs der Keramik mit einem Elektronenstrahl und das Messen von Strom, Spannung oder von der Elektrode gesammelter Ladung beinhaltet.

11. Vorrichtung zur Durchführung des Verfahrens nach Anspruch 7, welche zusätzlich zu der Elektrode in Form einer biegsamen Folie einen im wesentlichen starren Befestigungskörper mit einem mit Ausnahme von Durchbrüchen in einer Wand desselben umschlossenen Hohlraum, wobei die biegsame Folie die Durchbrüche abdeckt und mit dem Befestigungskörper längs des Randes des durchbrochenen Wandbereichs dichtend verbunden ist, wobei die Folie eine der Probe zugekehrte elektrisch leitende Oberfläche aufweist; und Mittel zum Halten des Randes der zu untersuchenden ungesinterten Einschicht- oder Mehrschichtkeramik gegen die biegsame Folie umfaßt, wobei der Gasdruck innerhalb des umschlossenen Hohlraums derart ist, daß während der Untersuchung der Keramik die biegsame Folie durch einen höheren Gasdruck innerhalb des Hohlraums, als es der Gasdruck an der Keramik ist, in gleichförmigem Kontakt mit der Keramik gehalten wird.

12. Vorrichtung nach Anspruch 11, welche eine Elektronenstrahlkammer aufweist, welche die Keramik und den Befestigungskörper enthält und welche evakuiert werden kann.

13. Vorrichtung zur Durchführung des Verfahrens nach Anspruch 1, bei welcher die sich anpassende Elektrode ein samtartiges elektrisch leitendes Material mit abragenden leitenden Fasern umfaßt.

14. Vorrichtung nach Anspruch 13, bei welcher die Fasern Kohlenstoffasern umfassen.

8

FIG. 1

FIG. 2.2

# FIG. 2.1

FIG. 3

42

118

116

113

114

10

FIG. 4

124

122

10